(19) **Europäisches Patentamt**
**European Patent Office**
**Office européen des brevets**

(11) **EP 4 377 884 B1**

(12) # EUROPEAN PATENT SPECIFICATION

(45) Date of publication and mention
of the grant of the patent:
**10.06.2026 Bulletin 2026/24**

(21) Application number: **22773103.1**

(22) Date of filing: **25.07.2022**

(51) International Patent Classification (IPC):
***G06T 7/00*** *(2017.01)*

(52) Cooperative Patent Classification (CPC):
**G06T 7/001;** G06T 2207/10061; G06T 2207/20016;
G06T 2207/30148

(86) International application number:
**PCT/EP2022/025344**

(87) International publication number:
**WO 2023/006241 (02.02.2023 Gazette 2023/05)**

(54) **METHOD FOR DEFECT DETECTION IN A SEMICONDUCTOR SAMPLE IN SAMPLE IMAGES WITH DISTORTION**

VERFAHREN ZUR FEHLERERKENNUNG IN EINER HALBLEITERPROBE IN PROBEBILDERN MIT VERZERRUNG

PROCÉDÉ DE DÉTECTION DE DÉFAUTS DANS UN ÉCHANTILLON SEMI-CONDUCTEUR DANS DES IMAGES D'ÉCHANTILLON À DISTORSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.07.2021 DE 102021119008**

(43) Date of publication of application:
**05.06.2024 Bulletin 2024/23**

(73) Proprietor: **Carl Zeiss MultiSEM GmbH
73447 Oberkochen (DE)**

(72) Inventors:
 • **KORB, Thomas
 73525 Schwaebisch Gmuend (DE)**
 • **NEUMANN, Jens Timo
 73434 Aalen (DE)**
 • **HOFMANN, Ulrich
 81375 Muenchen (DE)**

 • **MEYER, Sven
 69231 Rauenberg (DE)**
 • **CHUST, Thomas, C.
 81549 Muenchen (DE)**

(74) Representative: **Tesch-Biedermann, Carmen
Athene Patent
Hanns-Schwindt-Straße 11
81829 München (DE)**

(56) References cited:
**US-A1- 2016 125 583   US-A1- 2019 114 758
US-A1- 2019 122 913**

 • **A.L. EBERLE ET AL: "High-resolution, high-throughput imaging with a multibeam scanning electron microscope : HIGH-THROUGHPUT IMAGING WITH A MULTIBEAM SEM", JOURNAL OF MICROSCOPY, vol. 259, no. 2, 1 August 2015 (2015-08-01), GB, pages 114 - 120, XP055644403, ISSN: 0022-2720, DOI: 10.1111/jmi.12224**

## Description

Field of the invention

The invention relates to a method for defect detection in a sample, in particular in a semiconductor sample, wherein sample images are generated by means of a particle beam inspection system. The particle beam inspection system can be in particular a multiple particle beam inspection system.

Prior art

With the continuous development of ever smaller and ever more complex microstructures such as semiconductor components, there is a need to develop and optimize planar production techniques and inspection systems for producing and inspecting small dimensions of the microstructures. By way of example, the development and production of the semiconductor components requires monitoring of the design of test wafers, and the planar production techniques require process optimization for a reliable production with a high throughput. Moreover, there have been recent demands for an analysis of semiconductor wafers for reverse engineering and for a customer-specific, individual configuration of semiconductor components. Therefore, there is a need for inspection means which can be used with a high throughput for examining the microstructures on wafers with great accuracy.

Typical silicon wafers used in the production of semiconductor components have diameters of up to 300 mm. Each wafer is divided into 30 to 60 repeating regions ("dies") with a size of up to 800 mm². A semiconductor apparatus comprises a plurality of semiconductor structures, which are produced in layers on a surface of the wafer by planar integration techniques. Semiconductor wafers typically have a plane surface on account of the production processes. The structure sizes of the integrated semiconductor structures in this case extend from a few $\mu$m to the critical dimensions (CD) of 5 nm, with the structure sizes becoming even smaller in the near future; in future, structure sizes or critical dimensions (CD) are expected to be less than 3 nm, for example 2 nm, or even under 1 nm. In the case of the aforementioned small structure sizes, defects in the size of the critical dimensions must be identified quickly in a very large area. For several applications, the specification requirement regarding the accuracy of a measurement provided by inspection equipment is even higher, for example by a factor of two or one order of magnitude. By way of example, a width of a semiconductor feature must be measured with an accuracy of below 1 nm, for example 0.3 nm or even less, and a relative position of semiconductor structures must be determined with an overlay accuracy of below 1 nm, for example 0.3 nm or even less.

The MSEM, a multi-beam scanning electron microscope, is a relatively new development in the field of charged particle systems (charged particle microscopes, CPMs). By way of example, a multi-beam scanning electron microscope is disclosed in US 7 244 949 B2 and in US 2019/0355544 A1. In the case of a multi-beam electron microscope or MSEM, a sample is irradiated simultaneously with a plurality of individual electron beams, which are arranged in a field or raster. By way of example, 4 to 10 000 individual electron beams can be provided as primary radiation, with each individual electron beam being separated from an adjacent individual electron beam by a pitch of 1 to 200 micrometres. By way of example, an MSEM has approximately 100 separate individual electron beams ("beamlets"), which are arranged for example in a hexagonal raster, with the individual electron beams being separated by a pitch of approximately 10 $\mu$m. The plurality of charged individual particle beams (primary beams) are focused on a surface of a sample to be examined by way of a common objective lens. By way of example, the sample can be a semiconductor wafer which is fastened to a wafer holder that is mounted on a movable stage. During the illumination of the wafer surface with the charged primary individual particle beams, interaction products, for example secondary electrons or backscattered electrons, emanate from the surface of the wafer. Their start points correspond to those locations on the sample on which the plurality of primary individual particle beams are focused in each case. The amount and the energy of the interaction products depend on the material composition and the topography of the wafer surface. The interaction products form a plurality of secondary individual particle beams (secondary beams), which are collected by the common objective lens and which are incident on a detector arranged in a detection plane as a result of a projection imaging system of the multi-beam inspection system. The detector comprises a plurality of detection regions, each of which comprises a plurality of detection pixels, and the detector captures an intensity distribution for each of the secondary individual particle beams. An image field of for example 100 $\mu$m $\times$ 100 $\mu$m is obtained in the process.

The multi-beam electron microscope of the prior art comprises a sequence of electrostatic and magnetic elements. At least some of the electrostatic and magnetic elements are settable in order to adapt the focus position and the stigmation of the plurality of individual charged particle beams. The multi-beam system with charged particles of the prior art moreover comprises at least one cross-over plane of the primary or the secondary individual charged particle beams. Moreover, the system of the prior art comprises detection systems to make the setting easier.

The multi-beam particle microscope of the prior art comprises at least one beam deflector ("deflection scanner") for collective scanning of a region of the sample surface by means of the plurality of primary individual particle beams in order to obtain an image field of the sample surface. Further details regarding a multi-beam electron microscope and a method for operating same are described in the German patent application with the application number 102020206739.2, filed on May 28, 2020.

To detect defects in a semiconductor sample, images of the sample obtained by means of a scanning electron microscope or by means of other particle beam inspection systems, such as for example the MSEM described above, are used. Two conventional methods are based here on a comparison of a sample image with a reference image. This reference image can be a reference image that was likewise recorded by means of the charged particle beam inspection system ("die-to-die comparison", D2D). However, it is also possible to directly compare a sample image with the desired target design, wherein an emulated image can be generated for example on the basis of design data ("die-to-database comparison", D2DB). In both approaches, the images to be compared are compared pixel by pixel with one another. If there are deviations between the structures in the sample image compared with the reference image that are too great, these deviations are detected as defects.

One problem with this type of defect detection are distortions of structures in the sample images. If distortions occur, structures in the sample images are changed, for example offset and/or rotated compared to the structures in the reference image, and the deviations caused by the distortion in a pixel-based comparison between the sample image and the reference image are then marked as defects, although these deviations frequently do not constitute real defects. These undesired detections that mark what are not real defects are referred to as "false positives" or "nuisance". A reliable defect detection can become impossible due to these false-positive defects.

The distortions themselves can be affine distortions or non-linear distortions. One example of an affine distortion is a rotation of the sample image compared with the reference image. The causes of such a rotation may differ. A first possibility is, for example, that the sample is not aligned exactly ("misalignment") with respect to the particle beam inspection system. It is here possible in principle to place a sample on a sample holder only with a limited accuracy. Another cause for the occurrence of a rotation can be the electron lenses: In magnetic lenses, charged particles undergo a rotation due to the Lorentz force. This rotation is calibrated out with a corresponding calibration of the particle beam inspection system, but an image field rotation still occurs again regularly after a refocusing of the particle beam inspection system.

A further example of affine distortion in the sample image can be anisotropy of the pixel size, since the two scanning directions in a charged particle beam inspection system are normally independent of one another or can be set independently.

Non-linear distortions can occur for example due to non-linearities of the particle beam scan generator. Since this is a property of the particle beam inspection system, for example a scanning electron microscope, non-linearities can be reduced at least up to a certain point by way of a calibration. Another source of non-linear distortions are charges on the sample: These cannot be calibrated in principle.

In the cases described, the distortions bring about differences between the sample image and the reference image and subsequently result in numerous undesired false-positive defect detections.

It is possible to gain an impression of the meaning of the distortion mentioned when considering a simple example: The rotation of structures in a sample image is observed, with this rotation being only 1 mrad compared to the reference image: Assuming an edge length of 10 $\mu$m of the sample image, this rotation results in a feature shift by 0.001 rad x 10 000 nm = 10 nm from the left corner to the right corner, with this shift already being of the same order of magnitude as the size of defects that are intended to be found. With a direct comparison of structures of the sample image with corresponding structures in a reference image, many false-positive defects are therefore determined during a pixel-based comparison using conventional methods.

NAKAGAKI, Ryo; HONDA, Toshifumi; NAKAMAE, Koji. Automatic recognition of defect areas on a semiconductor wafer using multiple scanning electron images. Measurement Science and Technology, 2009, 20, p. 075503 discloses a method for defect detection with a scanning electron microscope which applies a single electron beam. To improve existing methods, said paper suggests to provide additional detectors so that several different images with different advantages for recognizing different kinds of defects can be generated simultaneously during one scan. The paper furthermore discloses a local registration to cope with an image distortion that arises from electrostatic charge of the surface of the sample when the beam moves in a scanning motion. This type of distortion is a non-linear distortion. The paper does not disclose a defect detection in an image comprising an affine distortion such as a rotation of a sample image with respect to a reference image. Furthermore, since a normalized cross correlation coefficient is used for the local registration, the method of the paper is not suited for a defect detection in images with an affine distortion such as a rotation.

US 2019/114758 A1 and US 2019/122913 A1 describe techniques for defect detection in semiconductor devices. The paper A.L. EBERLE ET AL: "High-resolution, high-throughput imaging with a multibeam scanning electron microscope : HIGH-THROUGHPUT IMAGING WITH A MULTIBEAM SEM", JOURNAL OF MICROSCOPY, vol. 259, no. 2, 1 August 2015, pages 114-120, GB, ISSN: 0022-2720, DOI: 10.1111/jmi.12224 discloses multiple beam scanning electron microscopes and hints at wafer inspection in one embodiment.

Description of the invention

It is thus the object of the present invention to improve a method for defect detection in a sample and in particular in a semiconductor sample. The method for defect detection should provide reliable results in particular even if the sample image has a distortion and in particular if the sample image comprises a rotation with respect to a reference image. Furthermore, the method shall also be applicable to multi beam particle microscopes and their particular characteristics.

The object is achieved by the subject matter of the independent claims. Advantageous embodiments of the invention are evident from the dependent claims.

The present patent application claims the priority of German patent application 10 2021 119 008.8 with the filing date July 30th, 2021.

According to a first aspect of the invention, the latter relates to a method for defect detection in a sample, in particular in a semiconductor sample, said method including the following steps:

> a) providing a reference image of the sample;
> b) providing a sample image generated by means of a particle beam inspection system, wherein the sample image comprises a rotation with respect to the reference image;
> c) dividing the sample image into sample image regions;
> d) dividing the reference image into reference image regions, wherein each sample image region is assigned one reference image region to form an image region pair;
> e) identifying in each image region pair a structure that is present both in the sample image region and also in the associated reference image region of the image region pair;
> f) registering the sample image regions by correcting a lateral offset of the identified structure in each sample image region on the basis of the location of the identified structure in the respectively associated reference image region, as a result of which corrected sample image regions are formed; and
> g) comparing each corrected sample image region pixel by pixel with the respectively associated reference image region for defect detection.

According to the invention, a sample image is generated by means of a particle beam inspection system. It is possible that the sample image is generated "on-the-fly" during the method for defect detection. However, it is also possible that the sample image was already generated prior to the method for defect detection. The particle beam inspection system can be in particular any particle beam inspection system. It may be an individual particle beam system, for example an individual beam electron microscope (SEM) or a helium ion microscope (HIM). However, it is also possible that the particle beam inspection system is a multi-beam particle beam system, for example a multi-beam electron microscope (MSEM). In the context of the definitions of the present patent application, a sample image is in any case generated with an individual assigned charged particle beam. In line with the definition, the sample image is thus not an image that is composed of a plurality of individual images; such a composed image would correspond to a plurality of sample images.

According to the invention, the sample image can have distortions, in particular the sample image comprises a rotation with respect to the reference image as a distortion.. The method for defect detection in a sample provides good results even if the sample image has such distortions and in particular even if the sample image comprises a rotation with respect to the reference image However, it is of course nevertheless possible to use the method for defect detection even in sample images that have no distortions. It is also frequently the case that it is not exactly known in advance whether distortions are present or what type of distortions they are. In this situation, the method for defect detection according to the invention offers significant added value.

According to the invention, a reference image of the sample is provided. This reference image can be an emulated image of the sample, which is based for example on specified design data of the sample, or of the semiconductor sample. However, it is also possible that the reference image is a further recording of a sample or of an identical or comparable sample that is or has been recorded with the same or another particle beam inspection system as the sample image provided.

According to the invention, the sample image is divided into sample image regions (patches). Preferably, all sample image regions have the same dimensions. For example, they can be rectangular or square, but parallelogram shapes or other shapes are also possible. The use of sample image regions having identical dimensions simplifies the subsequent registration method.

According to the invention, the reference image is also divided into reference image regions, wherein each sample image region is assigned one reference image region to form an image region pair. The dimensions of the reference image and of the sample image here match or are correspondingly scaled such that a match exists. The dimensions of a sample image region and of an associated reference image region are preferably identical in each case, which allows a best possible assignment to image region pairs to be achieved.

According to the invention, in each image region pair a structure that is present both in the sample image region and also in the associated reference image region of the image region pair is identified. This structure serves as a starting structure for the subsequent registration. Said structure is an easy-to-recognize structure which should be capable of being identified without any doubt in each of the image regions. How such a structure is to be selected and identified is sufficiently known from the prior art. For example, US,6,921,916 B2, US 6,580,505 B1 and US 5,777,392 A disclose fundamental details relating to registration methods and marker structures.

According to the invention, registering the sample image regions is effected by correcting a lateral offset of the identified structure in each sample image region on the basis of the location of the identified structure in the respectively associated reference image region, as a result of which corrected sample image regions are formed. A lateral offset of the identified structure is corrected. Since the sample image comprises a rotation with respect to the reference image as a distortion, the identified structures in each sample image region are also rotated to a certain degree. However, here, this rotation is shift-corrected, only. In illustrative terms, each sample image region is thus shifted during the registration operation. Using a pure shifting operation, the identified structures in each image region pair are made to substantially coincide with one another. Rather than a common/single-step registration of the entire sample image, the invention makes provision for a registration of partial regions, specifically of the sample image regions. Owing to the fact that only a lateral offset is corrected, conventional registration routines are capable of performing the registration. Owing to the fact that one registration per sample image region is carried out, distortions in the sample image during registration have only an insignificant effect, if any at all. While in the case of a distortion in the entire sample image there exist significant deviations from the entire reference image so that the complete sample image cannot be made to coincide with the reference image with respect to the structures imaged therein by way of shifting operations, this is successful when registering the smaller sample image regions.

If the pixel-based comparison of each corrected sample image region with the respectively assigned reference image region for defect detection takes place, this pixel-based comparison will yield practically no false-positive defects during the defect detection, or the occurrence thereof will be significantly reduced in any case. This effect becomes clear upon closer examination of the geometric situations and size relationships of structures in the sample image regions when distortions occur in the sample image:

According to a preferred embodiment of the invention, a distortion of the sample image is small, and, for the associated shift $|\vec{\Delta}(\vec{r})|$ :

$$|\vec{\Delta}(\vec{r})|/\min(w_x, w_y) \ll 1 \qquad (1)$$

In this case, $\vec{r}$ denotes a position in the field of view $w_x \times w_y$ and $\vec{\Delta}$ denotes the associated shift. If this equation is satisfied, the structures in the sample image are still situated in the vicinity of their expected positions. In this case, an initial registration of the individual sample image regions with respect to the assigned reference image regions will succeed. By way of example, a field of view (FOV) of an individual beam scanning electron microscope with 10 $\mu$m shall be considered. A rotation of the structures located therein by 1 mrad shifts the structures located therein from their expected position (expected position in the reference image) by no more than 10 nm.

According to a preferred embodiment of the invention, the structures of the dimension CD, which are to be examined with respect to defects, in the sample image are small and the following applies:

$$\sqrt{(\partial_x\Delta_x)^2 + \left(\partial_x\Delta_y\right)^2} \ll 1 \qquad (2a)$$

inside a window with the dimension $CD_x$
and

$$\sqrt{\left(\partial_y\Delta_x\right)^2 + \left(\partial_y\Delta_y\right)^2} \ll 1 \qquad (2b)$$

inside a window with the dimension $CD_y$

As a result, the conditions (2a), (2b) mean that the distortion does not vary too greatly from location to location. A structure thus practically does not change its shape due to the distortion (a bar does not become a serpentine and vice versa). The two conditions (1) and (2a) or (2b) mentioned above are normally satisfied anyway in existing semiconductor defect detection methods. For example, let a structure have a spatial extent of 50 nm and experience a rotation by 1 mrad due to a distortion. This structure then experiences a local distortion which is no greater than 0.05 nm, which in turn lies below the typical resolution limit of a particle beam inspection system. Typical shifts that can occur for structures lie in the order of magnitude of approximately 10 nm. Changes in the shape of the structures that frequently occur lie in a range of less than 1 nm, for example are approximately 0.1 nm, which lies below the resolution limit of a typical particle beam inspection system.

The conditions (2a), (2b) that a structure to be examined with respect to defects in the sample image is small should also be considered to have been met if the structure to be examined is meaningfully decomposable into a plurality of correspondingly small parts.

According to a preferred embodiment of the invention, the respective lateral offset of the respectively identified structure is corrected in two directions which are linearly independent with respect to one another, in particular in two mutually orthogonal directions. For example, a lateral offset is corrected in the x-direction and in the y-direction, with x and y being orthogonal to one another. This has computational advantages. However, it is also possible to provide a different coordinate system or reference system (for example a parallelogram).

The above general considerations also lead to requirements regarding a preferred size or dimension of the sample image regions. A sample image region must be large enough so that structures therein that are capable of registration can still be detected at all. In addition, a sample image region must be large enough so that, despite a relative shift between the sample image region and the assigned reference image region, a common image region content with mutually corresponding identifiable structures is still present. Calculations on the part of the inventors show that these requirements regarding the edge length of the sample image regions $A_{PB}$ are satisfied if:

$$A_{PB} \geq 5 \max_{\vec{r} \in Bild\_PB} \left| \vec{\Delta}(\vec{r}) \right| \qquad (3)$$

The size or dimension of a sample image region should thus be at least five times the size of a maximally occurring distortion. This preferably applies to each direction in which the lateral offset is corrected, in other words for example in a Cartesian coordinate system in the direction x and direction y. The size of a maximally occurring distortion can here be estimated or calculated, and in particular it is dependent on the type of the distortion that occurs. On this basis, the dimension of the sample image regions can be determined according to equation (3).

In other words, a sample image region must not be too small. On the other hand, a sample image region must not be too large either - otherwise the above-described problems in a one-step registration of the entire sample image according to the prior art occur. Calculations on part of the inventors have shown that it is advantageous if a location-dependent distortion does not change more significantly over a sample image region than approximately half the defect size which is sought as part of the defect detection. Otherwise, the result of the distortion would be that the sample image region and the assigned reference image region cannot be made to coincide with one another by registration, but that, in the difference image region between the sample image region and the assigned reference image region, there will always be a signal of more than half a defect size which would then be incorrectly interpreted as a false-positive defect. Mathematically, this gives the following estimate:

$$A_{PB} \leq A_{Def} * \left( \frac{1}{\left| grad \left| \vec{\Delta} \right| \right|} \right) \qquad (4)$$

Here, $A_{Def}$ denotes the defect size and $\left| grad \left| \vec{\Delta} \right| \right|$ denotes the absolute value of the gradient of the location-dependent distortion or shift. This absolute value of the gradient may be imagined illustratively according to an example as a shift of the corners of a sample image region with respect to one another (compression or extension of the corner-to-corner distance due to the distortion). The corner-to-corner distance may not change due to the distortion by more than approximately half the defect size.

If rotations occur as the distortion, a maximum size of the sample image regions $A_{PB}$ is particularly small. Consequently, a decomposition of the sample image into particularly small sample image regions is necessary. On the other hand, it is an objective to perform successful registration with as few decompositions as possible. It is therefore preferred that (detectable) rotations are detected and corrected prior to the defect detection according to the invention (also) by means of another method. In that case, the sample image regions can be selected to be larger, and the rotations which would otherwise not be detectable can be corrected.

According to a preferred embodiment of the invention, a size of the sample image regions is selected, when dividing the sample image, such that a shape of the sample image regions does not substantially change due to the distortion. The size of the sample image regions must thus additionally be selected to be small enough for the described condition to be satisfied. A typical size for a sample image region is here approximately 1 to 5 $\mu$m, preferably 1 to 3 $\mu$m, for example 2 $\mu$m.

According to a preferred embodiment of the invention, the sample image regions are quadrangular, in particular rectangular or square, and the distances between the corners of the sample image regions are shifted relative to one another with respect to the distances between the corners of the associated reference image regions relative to one another due to the distortion in the sample image by no more than a predetermined number of pixels.

According to a preferred embodiment of the invention, distances between the corners of the sample image regions are shifted relative to one another with respect to the associated distances between the corners of the reference image regions relative to one another due to the distortion by no more than half an expected defect size.

According to a preferred embodiment of the invention, mutually adjacent sample image regions have an overlap, wherein the respective overlap is selected to be at least as large as the size of an expected defect. The overlap between adjacent sample image regions is in any case preferably selected to be the same size. However, it is also possible for the overlap to be selected to be different, for example to select a differently sized overlap in the x-direction and y-direction. If the set overlap is selected to be at least as large as the size of an expected defect, any such defect is imaged entirely in at least one sample image region. When counting defects, care may have to be taken to avoid counting the same defect twice.

According to a preferred embodiment of the invention, the sample image has, in addition to the rotation, another affine distortion with respect to the reference image, and/or the sample image has a non-linear distortion with respect to the reference image. An affine distortion requires that points and straight lines of the space are mapped to points and straight lines while maintaining collinearity. The division ratio of any three points on any straight line is maintained (preservation of division ratio) and each pair of parallel straight lines is mapped to a pair of parallel straight lines (preservation of parallelism). Examples of an affine distortion are rotations (for example due to misalignments in the sample placement or to image field rotation of charged particle beams) and the aforementioned anisotropy in the pixel size. Examples of a non-linear distortion are distortions due to non-linearities in the beam generation and due to sample charging. It is possible that different effects overlay one another in the distortion, in other words that a distortion overall is the result of a plurality of incorrect imagings/distortions. Defect detection can in principle be successfully applied with the aid of the method according to the invention to all types of distortions. However, special emphasis should be given to the successful application of the method if a distortion in the form of a rotation is present, because, for one part, this type occurs particularly frequently and, for the other, existing registration methods frequently fail in the case of this type of distortion. It is advantageous to correct rotations as far as possible even before the method according to the invention is carried out. The remaining correction of the rotation is then taken care of as part of the method according to the invention with its specific strengths.

According to a preferred embodiment of the invention, the method furthermore includes the following step: determining a distortion function or a distortion pattern for the sample image on the basis of the corrected lateral offset of the sample image regions during registration. Preferably, a distortion function or a distortion pattern is determined on the basis of the corrected lateral offset of all sample image regions. The more data have been used to determine the distortion function or the distortion pattern, the more precise is the determination of the function or of the pattern. It is possible for example to examine the available data with respect to the corrected lateral offset for the distortion pattern rotation. It is possible here to hypothetically assume a rotation as the distortion, and it is possible to determine whether, at a specific rotation angle, the corrected sample image regions are in fact offset corresponding to the expectation/-preview. A rotation angle that is as exact as possible can then be determined iteratively. Therefore, preferably, the method comprises determining a rotation angle of the sample image with respect to the reference image.

According to a preferred embodiment of the invention, the method furthermore includes the following step: adjusting and/or calibrating the particle beam inspection system on the basis of the distortion function and/or the distortion pattern. It is thus possible to reduce or entirely prevent the distortion in further recordings by means of the particle beam inspection system.

According to a preferred embodiment of the invention, the method furthermore includes the following step: coarsely registering the sample image with respect to the reference image. This coarse registration is performed here before the actual fine registration or the registration according to the invention as part of the method for defect detection according to the invention. For coarse registration, the well-known registration methods from the prior art can be used alone or in combination. After a coarse registration, the sample image and the associated reference image should preferably lie on top of one another at least sufficiently well so that, as part of the method according to the invention, the sample image regions produced by the division and their associated reference image regions are not completely disjunct, but have structures that at least partially really correspond to one another. **If** the latter is not possible for all sample image regions, the condition should be satisfied at least for as many sample image regions as possible. Pre-registration can be very important in particular in a D2D method, since it is not ensured in a D2D method that the same is actually seen in images from two different measurements, for example because inaccuracies in the range of approximately 0.5 μm to 1 μm may certainly occur due to positioning errors of the sample stage. To this extent, and as far as possible, a pre-registration should also involve pre-correcting the rotations in the sample image, which have already been mentioned multiple times, with respect to the reference image.

According to a preferred embodiment of the invention, the particle beam inspection system is an individual particle beam system, in particular an individual beam electron microscope (SEM) or a helium ion microscope (HIM). However, it could also be another individual particle beam system.

According to a further preferred embodiment of the invention, the particle beam inspection system is a multiple particle beam system, in particular a multi-beam electron microscope (MSEM), operating with a plurality of individual particle beams. However, it is also possible to use a different multiple particle beam system with different charged particles as particle beam inspection system.

According to a preferred embodiment of the invention, the described method is performed for a plurality of sample images, wherein each sample image is generated by means of an individual particle beam associated therewith. A multi-image is here composed of a plurality of individual images (sample images). In principle, the described method can be performed here for each sample image.

There are multiple particle beam systems that operate with a plurality of columns. That means that individual particle beams are guided through an individual particle optical unit for the individual particle beam. In principle, distortions of an individual type can occur within each of the columns. For example, it is possible that an image field rotation of an individual particle beam occurs within each column. This effect per column can also be overlaid by a general rotation, which is caused for example by a misalignment of the sample to be examined on the sample holder. The method according to the invention works in the case of such distortions.

There are also multi-beam particle beam systems that operate with a single column. According to a preferred embodiment, the multiple particle beam system comprises a single column for the plurality of individual particle beams. Here, the plurality of individual particle beams travel through the same particle optical unit (wherein it is not ruled out that individual particle beams are nevertheless individually influenced at some points in the particle-optical beam path; however, frequently there are magnetic lenses through which all individual particle beams travel together, for example an objective lens, a condenser lens and/or a field lens or corresponding systems). If each individual particle beam is assigned a sample image (single field of view, sFOV), wherein the sample images are composed to form an overall sample image (multi-field of view, mFOV), the situation for a distortion in single-column systems is different than in multi-column systems: As they pass through only one column, the individual particle beams in their entirety undergo an image field rotation, the individual sample images are thus not additionally rotated with respect to one another. Image field rotation and a rotation due to inaccurate positioning of a sample with respect to the sample holder can in this case add up. In principle, the described method for defect detection can here also be carried out for each sample image individually.

In order to still further improve the method for defect detection overall even when using multiple particle beam systems, according to a preferred embodiment, the method is carried out for the plurality of sample images in a shell-wise manner. A shell-wise process proceeds from a base sample image. This sample image can be located centrally within the plurality of the sample images, but it is also possible that it is located laterally offset with respect thereto or, for example, near a peripheral region. If a centrally arranged sample image is used as the starting point, a plurality of complete shells around said central sample image can be defined by other sample images arranged around the central, or base, sample image. If the base sample image is not centrally arranged, the shells are possibly not complete, but the term shell-wise is still used in connection with the invention. The registration of the sample images as such is still carried out for each sample image in a sample image region-wise manner and with shift correction within the sample image regions, only. Furthermore, the defect detection as such is carried out pixel by pixel by comparing the corrected sample image regions with the respectively associated reference image regions. However, the order according to which the registration and defect detection is carried out for the plurality of sample images is of importance and this order is shell-wise. Before a defect detection is carried out in a new/ more outer shell, an additional correction of positions of sample images within that shell can be carried out. For example, the centre positions of the sample images can be positionally corrected and/ or an overall orientation of the sample images can be corrected. Then, in the registration step before the pixel-by-pixel defect detection step as such, only lateral offsets of identified structures are corrected. The shell-wise process contributes to reducing errors occurring due to error propagation in particular in the presence of rotations as distortions. The more sample images (sFOVs) are present in a multi-image (mFOV), the more important this error reduction becomes.

According to a preferred embodiment of the invention, the sample images are arranged hexagonally with respect to one another and/or the sample images have an overlap with adjacent sample images. By means of a hexagonal arrangement of the individual sample images, overall hexagonal multi-sample images are formed, which in turn can be placed with further multi-sample images one next to the other in the manner of tiles (tessellation). Therefore, a multiple particle beam system preferably operates with $3n(n-1)+1$ individual particle beams, with n denoting a natural number. However, it is also possible that the sample images are arranged differently with respect to one another, for example in the manner of a chequerboard. The overlap between different sample images makes it easier to stitch together the sample images to form a multi-sample image.

According to a preferred embodiment of the invention, the method furthermore includes the following steps:

> selecting a sample image as base sample image;
> carrying out the method steps a) to g) for defect detection for the base sample image;
> selecting first sample images that are arranged in a first shell around the base sample image; and
> carrying out the method steps a) to g) for defect detection for the first sample images.

The base sample image selected is preferably a sample image in which an easy-to-identify structure is shown. In each case, a base sample image should be registered securely because the further registration and later also the defect detection build up from this registration of the base sample image. Once the base sample image is correctly registered, and with the described prerequisites (distortion of the sample image is small and structures to be examined with respect to defects in the sample image are small), registration of the first sample images and defect detection in the corrected (registered) sample images of the first shell around the base sample image takes place. If the sample images are arranged hexagonally with respect to one another, the first (complete) shell around the base sample image comprises six further sample images. The sample images are here registered, as has already been described further above, sample image region by sample image region, by correcting a lateral offset of the structure identified in each sample image region, and corrected sample image regions are formed for all sample image regions. The detailed statements above apply accordingly.

According to a preferred embodiment of the invention, the method furthermore includes the following step: determining a first angle of rotation for the distortion based on the sample image region-wise registration of the first individual sample images of the first shell.

The determined first angle of rotation here describes a rotation as a distortion in a first approximation.

According to a preferred embodiment of the invention, the method includes the following steps:

selecting second sample images that are arranged in a second shell around the base sample image; correcting a position of the second sample images based on the determined first angle of rotation; and carrying out the method steps a) to g) for defect detection for the position-corrected second sample images..

The second shell can again be a closed shell or merely a partial shell. If the sample images are arranged in a hexagonal arrangement, a complete second shell has 12 second sample images. The second sample images are registered on the basis of the determined first angle of rotation. In this case, it is extrapolated, for example, in what way/to what extent the second sample images shift if it is also true for the second sample images of the second shell that they are rotated by the first angle of rotation. The reference to the determined first angle of rotation thus ensures simplified starting conditions in the registration, in which - as is the case in principle - sample image regions are registered sample image region-wise by correcting a lateral offset of identified structures.

According to a preferred embodiment of the invention, the method furthermore includes the following step: determining a second angle of rotation for the distortion based on the sample image region-wise registration of the second sample images of the second shell.

With this determination of the second angle of rotation, the existing value of the first angle of rotation is improved. First, significantly more second sample images are arranged in the second shell around the base sample image than in the first shell around the base sample image. The data basis for determining the second angle of rotation is thus improved. Second, as the distance from the centre of rotation increases, the accuracy with which an angle of rotation can be determined increases.

According to a preferred embodiment of the invention, the method furthermore includes the following steps:

selecting third sample images that are arranged in a third shell around the base sample image; correcting a position of the third sample images based on the determined second angle of rotation; and carrying out the method steps a) to g) of defect detection for the position-corrected third individual sample images..

The third shell can again be a complete shell or a partial shell. If the individual sample images are arranged hexagonally with respect to one another (tessellation), a complete third shell has 18 individual sample images. The third individual sample images are then registered based on the determined second angle of rotation. Here, too, the second angle of rotation determined in the previous method step is used to provide better starting conditions for the defect detection/ registration process for the registration of the third individual sample images in the third shell. In addition, it is possible, based on the registration of the third individual sample images of the third shell, to determine a third angle of rotation for the distortion. In the manner described, the method can be carried out for a further shell or for further shells, wherein these shells can again be complete shells or merely partial shells. The method described is thus iterative with respect to the determination of the angle of rotation, and with each iteration the angle of rotation typically becomes determinable with greater accuracy. The further to the outside the registration of the sample images moves starting from the base sample image, the more important it also becomes to take into account the determined angle of rotation as part of the registration: Without previously taking the angle of rotation determined in the prior method step into account, the higher the likelihood that registration of the sample images in farther away situated shells fails. A situation would arise in which, without taking the angle of rotation into consideration, a search would take place for a registration in regions of the reference image of the sample that only has a few regions or does not have any regions in common with the actually associated regions/regions of interest of the sample image. For the reason described, the shell-wise registration of the sample images makes an important contribution to a method for defect detection in a sample in the case of distortions in sample images obtained by means of a multiple particle beam inspection system.

According to a further aspect of the invention, the latter relates to a computer program product having a program code for carrying out the method, as has been described above in various embodiment variants and examples. In this case, the program code can be divided into one or more partial codes. The code can be written in any desired programming language.

The described embodiments of the invention can be combined with one another in full or in part, provided that no technical contradictions arise as a result.

The invention will be understood even better with reference to the accompanying figures, in which:

Fig. 1: shows a schematic illustration of a multi-beam particle microscope (MSEM);
Fig. 2: schematically illustrates a distortion in a sample image compared with a reference image;
Fig. 3: schematically shows a division of a sample

Fig. 4: schematically shows the result of a registration of sample image regions;

Fig. 5: schematically shows the determination of a distortion pattern in the form of a rotation;

Fig. 6: schematically shows effects of rotations on a plurality of sample images; and

Fig. 7: schematically shows distortion effects superposed on each other in sample images.

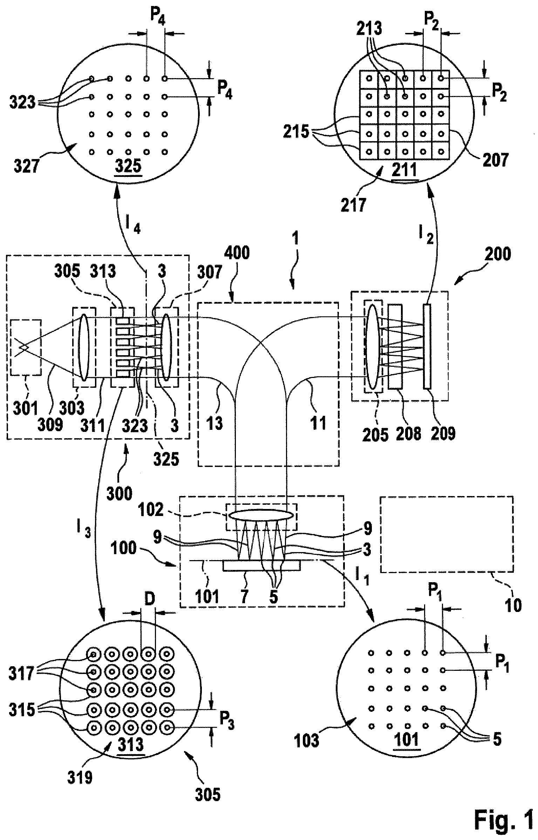

Figure 1 is a schematic illustration of a particle beam system 1 in the form of a multi-beam particle microscope 1, which uses a plurality of particle beams. The particle beam system 1 generates a plurality of particle beams which are incident on an object to be examined in order to generate there interaction products, e.g. secondary electrons, which emanate from the object and are subsequently detected. The particle beam system 1 is of the scanning electron microscope (SEM) type, which uses a plurality of primary particle beams 3 which are incident on a surface of the object 7 at a plurality of locations 5 and produce there a plurality of electron beam spots, or spots, that are spatially separated from one another. The object 7 to be examined can be of any desired type, e.g. a semiconductor wafer or a biological sample, and comprise an arrangement of miniaturized elements or the like. The surface of the object 7 is arranged in a first plane 101 (object plane) of an objective lens 102 of an objective lens system 100.

The enlarged detail I1 in Figure 1 shows a plan view of the object plane 101 having a regular rectangular field 103 of incidence locations 5 formed in the first plane 101. In Figure 1, the number of incidence locations is 25, which form a 5 x 5 field 103. The number 25 of incidence locations is a number chosen for reasons of simplified illustration. In practice, the number of beams, and hence the number of incidence locations, can be chosen to be significantly greater, such as, for example, 20 x 30, 100 x 100 and the like.

In the depicted embodiment, the field 103 of incidence locations 5 is a substantially regular rectangular field having a constant spacing P1 between adjacent incidence locations. Exemplary values of the spacing P1 are 1 micrometre, 10 micrometres and 40 micrometres. However, it is also possible for the field 103 to have other symmetries, such as a hexagonal symmetry, for example.

A diameter of the beam spots formed in the first plane 101 can be small. Exemplary values of said diameter are 1 nanometre, 5 nanometres, 10 nanometres, 100 nanometres and 200 nanometres. The focusing of the particle beams 3 for shaping the beam spots 5 is carried out by the objective lens system 100.

The primary particles incident on the object generate interaction products, e.g. secondary electrons, backscattered electrons or primary particles that have experienced a reversal of movement for other reasons and which emanate from the surface of the object 7 or from the first plane 101. The interaction products emanating from the surface of the object 7 are shaped by the objective lens 102 to form secondary particle beams 9. The particle beam system 1 provides a particle beam path 11 for guiding the plurality of secondary particle beams 9 to a detector system 200. The detector system 200 comprises a particle optical unit with a projection lens 205 for directing the secondary particle beams 9 at a particle multi-detector 209.

The detail I2 in Figure 1 shows a plan view of the plane 211, in which individual detection regions of the particle multi-detector 209 on which the secondary particle beams 9 are incident at locations 213 are located. The incidence locations 213 lie in a field 217 with a regular spacing P2 from one another. Exemplary values of the spacing P2 are 10 micrometres, 100 micrometres and 200 micrometres.

The primary particle beams 3 are generated in a beam generating apparatus 300 comprising at least one particle source 301 (e.g. an electron source), at least one collimation lens 303, a multi-aperture arrangement 305 and a field lens 307. The particle source 301 produces a diverging particle beam 309, which is collimated or at least substantially collimated by the collimation lens 303 in order to shape a beam 311 which illuminates the multi-aperture arrangement 305.

The detail I3 in Figure 1 shows a plan view of the multi-aperture arrangement 305. The multi-aperture arrangement 305 comprises a multi-aperture plate 313, which has a plurality of openings or apertures 315 formed therein. Midpoints 317 of the openings 315 are arranged in a field 319 that is imaged onto the field 103 formed by the beam spots 5 in the object plane 101. A spacing P3 between the midpoints 317 of the apertures 315 can have exemplary values of 5 micrometres, 100 micrometres and 200 micrometres. The diameters D of the apertures 315 are smaller than the distance P3 between the midpoints of the apertures. Exemplary values of the diameters D are 0.2 x P3, 0.4 x P3 and 0.8 x P3.

Particles of the illuminating particle beam 311 pass through the apertures 315 and form particle beams 3. Particles of the illuminating beam 311 which are incident on the plate 313 are absorbed by the latter and do not contribute to the formation of the particle beams 3.

On account of an applied electrostatic field, the multi-aperture arrangement 305 focuses each of the particle beams 3 in such a way that beam foci 323 are formed in a plane 325. Alternatively, the beam foci 323 can be virtual. A diameter of the beam foci 323 can be, for example, 10 nanometres, 100 nanometres and 1 micrometre.

The field lens 307 and the objective lens 102 provide a first imaging particle optical unit for imaging the plane 325, in which the beam foci 323 are formed, onto the first plane 101 such that a field 103 of incidence locations 5 or beam spots arises there. Should a surface of the object 7 be arranged in the first plane, the beam spots are correspondingly formed on the object surface.

The objective lens 102 and the projection lens arrangement 205 provide a second imaging particle optical unit for imaging the first plane 101 onto the detection plane 211. The objective lens 102 is thus a lens that is part of both the first and the second particle optical unit, while the field lens 307 belongs only to the first particle optical unit and the projection lens 205 belongs only to the second particle optical unit.

A beam switch 400 is arranged in the beam path of the first particle optical unit between the multi-aperture arrangement 305 and the objective lens system 100. The beam switch 400 is also part of the second optical unit in the beam path between the objective lens system 100 and the detector system 200.

Further information relating to such multi-beam particle beam systems and components used therein, such as, for instance, particle sources, multi-aperture plate and lenses, can be obtained from the international patent applications WO 2005/ 024881 A2, WO 2007/028595 A2, WO 2007/028596 A1, WO 2011/124352 A1 and WO 2007/060017 A2 and the German patent applications DE 10 2013 016 113 A1 and DE 10 2013 014 976 A1 .

The multiple particle beam system furthermore comprises a computer system 10, which is configured both for controlling the individual particle-optical components of the multiple particle beam system and for evaluating and analysing the signals obtained using the multi-detector 209. It can also be used to carry out the method according to the invention. In this case, the computer system 10 can be constructed from a plurality of individual computers or components.

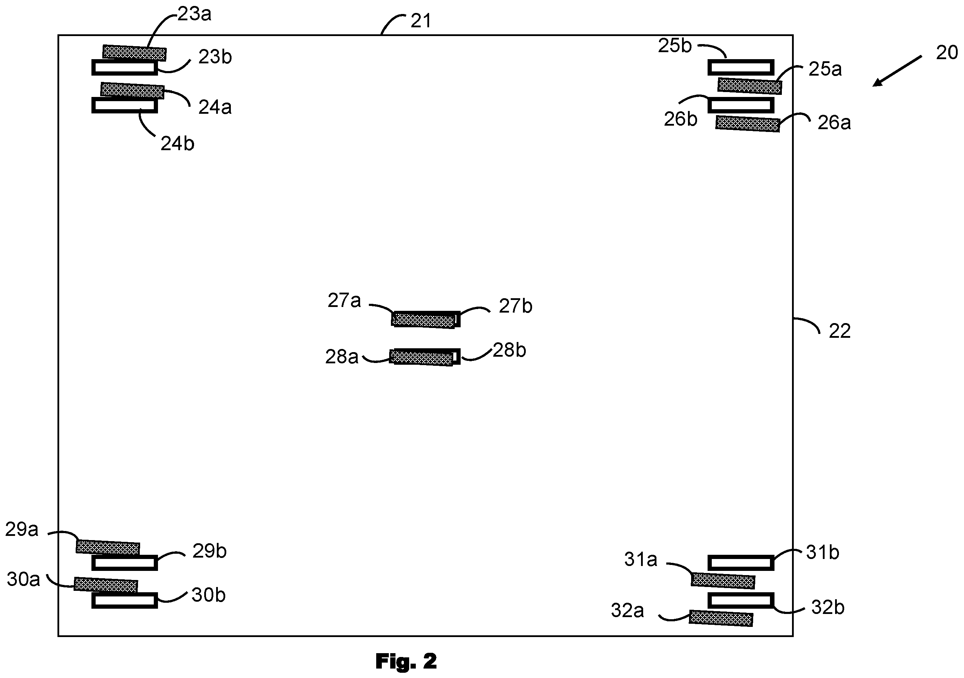

Figure 2 schematically illustrates a distortion in a sample image 20 compared with a reference image. The sample image 20 has been generated using an individual particle beam, wherein this individual particle beam can be the only particle beam of an individual particle beam inspection system or an individual particle beam from a plurality of individual particle beams 3 of a multiple particle beam system. The sample image 20 corresponds to, for example, an individual image field (single field of view, sFOV) of an MSEM. In the example shown, the sample image 20 is rectangular and has a long side 21 and a slightly shorter side 22. Typical dimensions of a sample image 20 are approximately 10 μm (short side 22,) or 12 μm (long side 21). The dimensions of the sides 21, 22 can also be larger or smaller, however.

The sample image 20 comprises a plurality of structures 23a to 32a, which are illustrated here by way of example as elongate bars. Likewise shown in the sample image 20 are structures 23b to 32b of an associated reference image. The sample image 20 and the reference image that is assigned to said sample image 20 form an image pair. The structures 23a to 32a are provided in figure 2 with a pattern fill, while the structures 23b to 32b assigned to the reference image are shown merely as outlines. Figure 2 shows that the respective structures 23a to 32a do not come to lie exactly on the reference structures 23b to 32b. In the central region of the sample image 20, the structures 27a and 27b and also 28a and 28b still lie on top of one another relatively well. However, in the region of the corners of the sample image 20, this is no longer the case at all: In the upper right corner, the structures 25a and 26a lie below and shifted to the right with respect to the reference structures 25b and 25b. In the bottom right corner of the sample image 20, the structures 31a and 32a are also shifted downwards, but in this case to the left. This also continues in the other corners of the sample image 20: The structures 29a and 30a in the bottom left corner are shifted upwards and to the left with respect to the reference structures 29b and 30b. The structures 23a and 24a in the upper left corner of the sample image 20 are shifted upwards and to the right with respect to the reference structures 23b and 24b.

When looking at the structures 23a to 32a in comparison with the reference structures 23b to 32b in Figure 2, it is immediately obvious that the structures cannot be made to coincide with one another using a pure shift or pure shifts. Instead, the structures 23a to 32a exhibit a distortion of the sample image 20 with respect to the reference image. If a conventional method for defect detection were carried out for the sample image 20, the result would be a plurality of false-positive defects: A pixel-based comparison of the corrected sample image 20 with the reference image provides many false-positive signals for defects because the associated structures a,b simply do not lie on top of one another at all at many positions. It is irrelevant here whether the reference image is a specially selected, since successful, sample image or whether the reference image is an emulated image on the basis of design data of a sample. The latter is, for example, generally typical for the defect detection in semiconductor samples (D2DB defect detection).

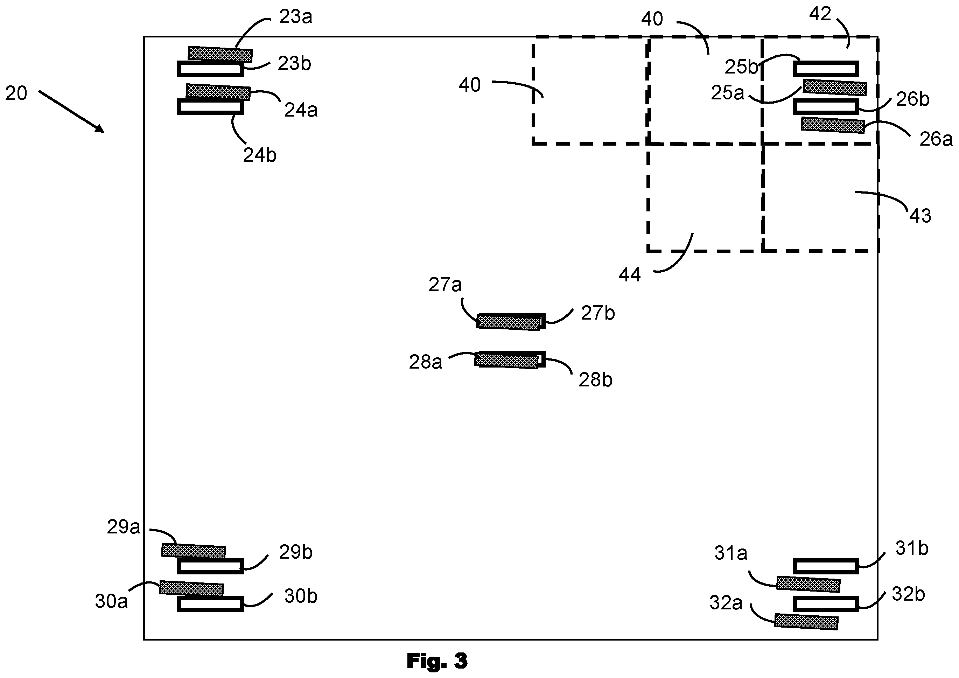

Figure 3 now illustrates a basic concept of the present invention and schematically shows a division of a sample image 20 into a plurality of sample image regions 40 to 44. The sample image regions 40 to 44 are illustrated here only as examples, of course the entire sample image 20 is divided into a plurality of sample image regions (in other words, Figure 3 does not show all the sample image regions). In the example shown, the sample image regions 40 to 44 or all the sample image regions have an identical size and identical dimensions. In the example shown, they are square and have, by way of example, an edge length of approximately 2 μm.

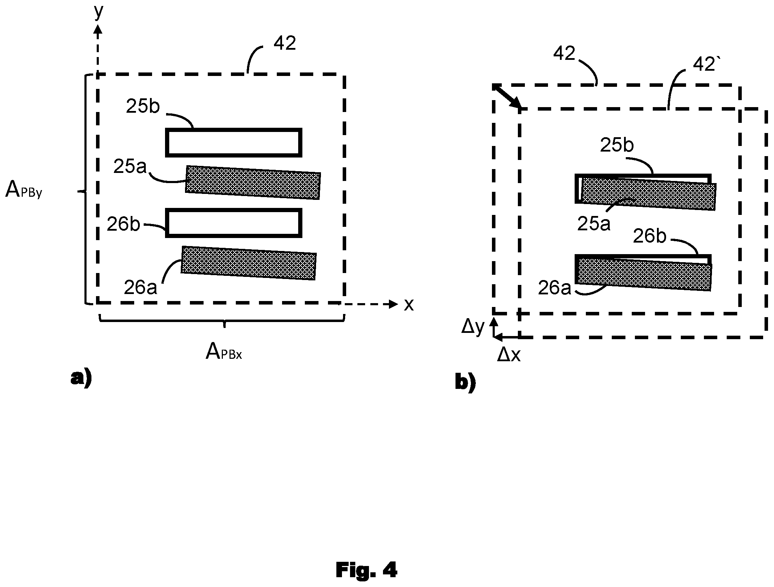

Figure 4 now illustrates, by way of example for the sample image region 42, registration of the sample image region 42: Registration is performed according to the invention by correcting a lateral offset of the identified structure or structures 25a and 26a on the basis of the location of the identified structure or structures 25b and 26b in the respectively assigned reference image region, as a result of which a corrected sample image region 42' is formed. Figure 4A shows the starting situation before the registration, Figure 4B shows the situation after the sample-image-region-wise registration: The structures 25a and 26a can be made to substantially coincide with the assigned structures 25b and 26b of the reference image by way of a lateral offset $\Delta x$, $\Delta y$. The deviation in the position of the structures in the sample image region compared with the position in the reference image region is very small and may even be so small that the deviation lies below the measurement accuracy/resolution of the particle beam system. In the example shown, the lateral offset is made in two directions that are mutually linearly independent, in the present case in the direction of the x-axis and the y-axis, which are orthogonal to each other. The axes x and y are correspondingly drawn in Figure 4A. Figure 4B shows the lateral offset $\Delta x$ and $\Delta y$.

The sample-image-region-wise registration makes it possible to significantly reduce or entirely prevent the number of false-positive defects during a defect detection which is pixel-based. If a pixel-based comparison of the corrected sample image region 42' with the associated reference image region is performed, the structures of the sample image region 25a and 26a lie so precisely on top of the structures 25b and 26b of the reference image region that the pixel-based defect detection does not provide a false positive defect.

It should be noted here that the position deviations are greatly exaggerated in the figures to illustrate the principle. The deviations can lie in particular below the detection limit or below the resolution of the particle beam inspection system.

In the example illustrated in Figure 3, the sample image regions 40 to 44 do not overlap. However, it is possible that the sample image regions 40 to 44 have an overlap with adjacent sample image regions that is selected to be at least as large as the size of an expected defect. This ensures that a real defect is actually visible in at least one of the sample image regions 40 to 44. If defects are counted, care should be taken that actually identical defects located in two sample image regions are not counted twice.

In the example illustrated in Figures 3 and 4, a distortion of the sample image 20 is small, and, for the associated shift $|\vec{\Delta}(\vec{r})|$ :

$$|\vec{\Delta}(\vec{r})| / \min\left(w_x, w_y\right) \ll 1 \qquad (1)$$

In this case, $\vec{r}$ denotes a position in the field of view $w_y$ x $w_y$ and $\vec{\Delta}$ denotes the associated shift. If this equation is satisfied, the structures 23a to 32a in the sample image 20 are still situated in the vicinity of their expected positions. In this case, an initial registration of the individual sample image regions 40 to 44 or of all the sample image regions with respect to the assigned reference image regions will succeed. By way of example, a field of view (FOV) of an individual beam scanning electron microscope with 10 $\mu$m shall be considered. A rotation of the structures located therein by 1 mrad shifts the structures located therein from their expected position (expect position in the reference image) by no more than 10 nm.

In the example illustrated in Figures 3 and 4, the structures 23a to 32a of the dimension CD, which are to be examined with respect to defects, in the sample image 20 are small and the following applies:

$$\sqrt{(\partial_x\Delta_x)^2 + \left(\partial_x\Delta_y\right)^2} \ll 1 \qquad (2a)$$

inside a window with the dimension $CD_x$
and

$$\sqrt{\left(\partial_y\Delta_x\right)^2 + \left(\partial_y\Delta_y\right)^2} \ll 1 \qquad (2b)$$

inside a window with the dimension $CD_y$

As a result, the conditions (2a), (2b) mean that the distortion does not vary greatly from location to location. A structure 23a to 32a thus practically does not change its shape due to the distortion (a bar does not become a serpentine and vice versa). The two conditions (1) and (2a) or (2b) mentioned above are normally satisfied anyway in existing semiconductor defect detection methods. For example, let a structure have a spatial extent of 15 nm and experience a rotation by 1 mrad due to a distortion. The structure then experiences a local distortion, which is no greater than 0.05 nm, which in turn lies below the typical resolution limit of a particle beam inspection system. Typical shifts that can occur for structures lie in the order of magnitude of approximately 10 nm. Changes in the shape of the structures that frequently occur lie in a range of less than 1 nm, for example are approximately 0.1 nm, which lies below the resolution limit of a typical particle beam inspection system.

In addition, in Figures 3 and 4, the two requirements (3) and (4) regarding the edge length $A_{PB}$ of the sample image regions 40 to 44 are satisfied - as discussed above in the general part of the patent application:

$$A_{PB} \geq 5 \max_{\vec{r} \, \in \, Bild\_PB} \left|\vec{\Delta}(\vec{r})\right| \qquad (3)$$

$$A_{PB} \leq A_{Def} * \left(\frac{1}{|grad|\vec{\Delta}||}\right) \qquad (4)$$

In accordance with equation (3), the size or dimension of a sample image region 40 to 44 is thus at least five times the size of a maximally occurring distortion. In the example shown, this applies to each direction in which the lateral offset is corrected, so in the example shown both in the x-direction and in the y-direction. In accordance with equation (4), a location-dependent distortion does not change more significantly over each sample image region 40 to 44 than approximately half the defect size $A_{Def}$ which is sought as part of the defect detection.

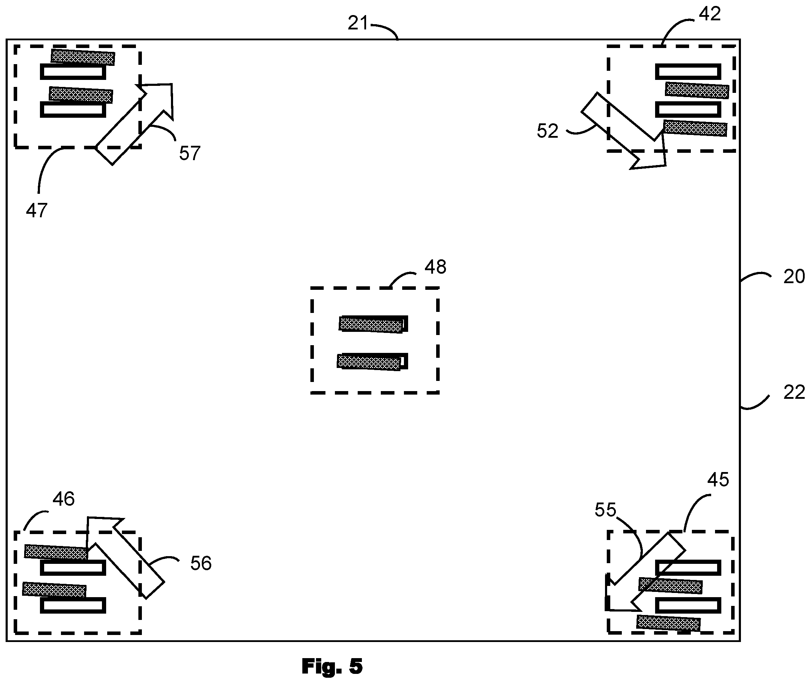

Figure 5 schematically shows the determination of a distortion pattern in the form of a rotation. Here, reference is once again made to the example illustrated in Figure 2, the structures illustrated in Figure 5 are identical to those in Figure 2. Upon consideration of the sample image regions 42, 45, 46, 47 and 48, it is possible to draw conclusions relating to a distortion function or a distortion pattern for the sample image 20 based on the shifts $\Delta x$, $\Delta y$ which are found per sample image region. The example shown is a rotation, which is indicated by corresponding arrows 52, 55, 56 and 57. The structures of the sample image regions 52, 55, 56 and 57 are rotated overall with respect to the sample image midpoint, or the one approximately centrally arranged sample image region 48. This rotation leads to different corrections of the lateral offset or to shifts in two dimensions $\Delta x$, $\Delta y$ in the different sample image regions 42, 45, 46 and 47. If a distortion function or a distortion pattern is known, it is possible based thereon to adjust and/or calibrate the particle beam inspection system. In future recordings, the sample images (and hence the sample image regions) then may have a smaller distortion or no distortion at all; this depends of course also on the type of the distortion found.

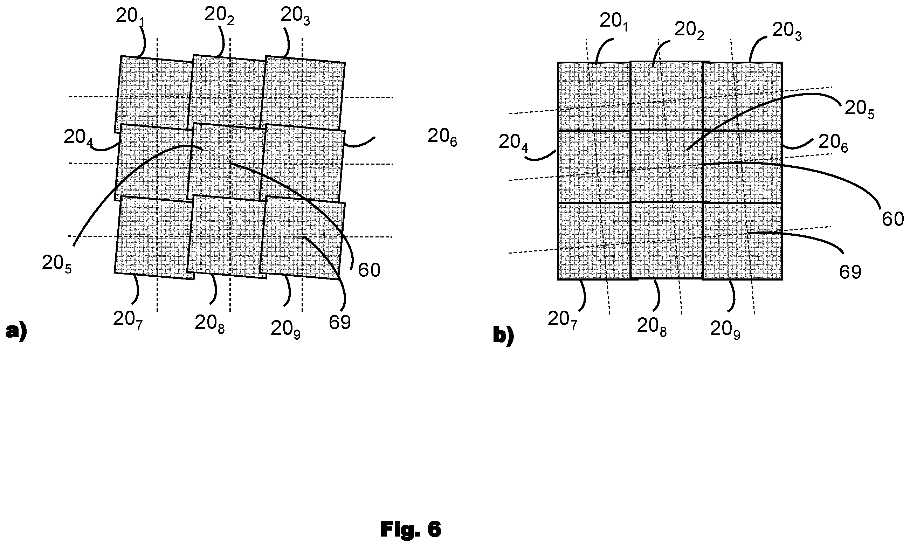

Figure 6 schematically illustrates effects of rotations on a plurality of sample images $20_1$ to $20_9$. The plurality of sample images $20_1$ to $20_9$ corresponds to a multi-field of view (mFOV), which can be obtained for example using a multi-beam electron microscope. In multiple particle beam systems, distortions that occur differ depending on the construction type of the inspection system: If the system is one having a plurality of columns, in which an individual electron beam or particle beam is guided through an optical unit that is specifically assigned to said beam, for example the pattern shown in Figure 6A or the distortion shown in Figure 6A is obtained: The midpoints of the sample images $20_i$ correspond to the midpoints of the reference images. Illustrated by way of example are the midpoints 60 and 69 of the sample images $20_5$ and $20_9$. Figure 6 likewise illustrates the coordinate system of the reference image or of the reference images by way of dashed lines. Although the midpoints lie one on top of the other, or are correctly arranged, a distortion exists nevertheless. The individual sample images $20_i$ are rotated with respect to the reference images in each case by approximately the same absolute value. In a pixel-based defect detection, a plurality of false-positive defects would - without the use of the method according to the invention - be detected during the registration of the entire multi-field of view or also during the registration of each sample image $20_i$ in one step, that is to say as a whole. However, this can be prevented by carrying out, according to the invention, registration of each sample image $20_i$ in each case for the sample image regions, as already described above.

Figure 6B shows an example of a different distortion, with the distortion being a rotation in this case, too. Unlike in Figure 6A, in which the rotation is caused by a field rotation in each particle optical unit of a column of the particle beam system, the distortion shown in Figure 6B can arise in two ways: First, it is possible that the sample to be examined (semiconductor sample) has been arranged only with limited precision on the sample holder and that a rotation has occurred in the process. However, it is also possible that the multiple particle beam inspection system according to Figure 6B is a multi-beam system having an individual column, wherein all individual particle beams 3 pass through a common particle optical unit. In the process, all the individual particle beams 3 possibly undergo an image field rotation as they pass through a magnetic field of a magnetic lens, for example as they pass through a common objective lens 102. In this case, the multi-field of view (mFOV) composed of the sample images $20_1$ to $20_9$ as a whole is shifted or rotated with respect to the centre 60. This can be seen for example upon consideration of the sample image $20_9$: Here, the centre of the sample image $20_9$ is no longer identical to the zero point of the coordinate system 69 of the reference image. If in the distortion situation illustrated in Figure 6B a registration of the individual sample images $20_i$ is carried out for each sample image $20_i$ completely, that is to say without any division into sample image regions, it becomes immediately clear that in a subsequent pixel-based comparison of the sample images $20_i$ with associated reference images numerous false-positive defects would be detected. The number of false-positive defects increases as the distance from the rotation centre 60 increases. Registration of the individual sample image regions per sample image $20_i$ here provides - as already described above - important improvements. However, it is nevertheless possible that in multi-beam systems a merely sample-image-region-wise registration for each sample image $20_i$ without further measures for a registration and subsequent pixel-based defect detection is not yet sufficient. For such an event, the invention proposes to register the plurality of sample images $20_i$ not only in a sample-image-region-wise manner, but in a shell-wise manner with respect to the sample images.

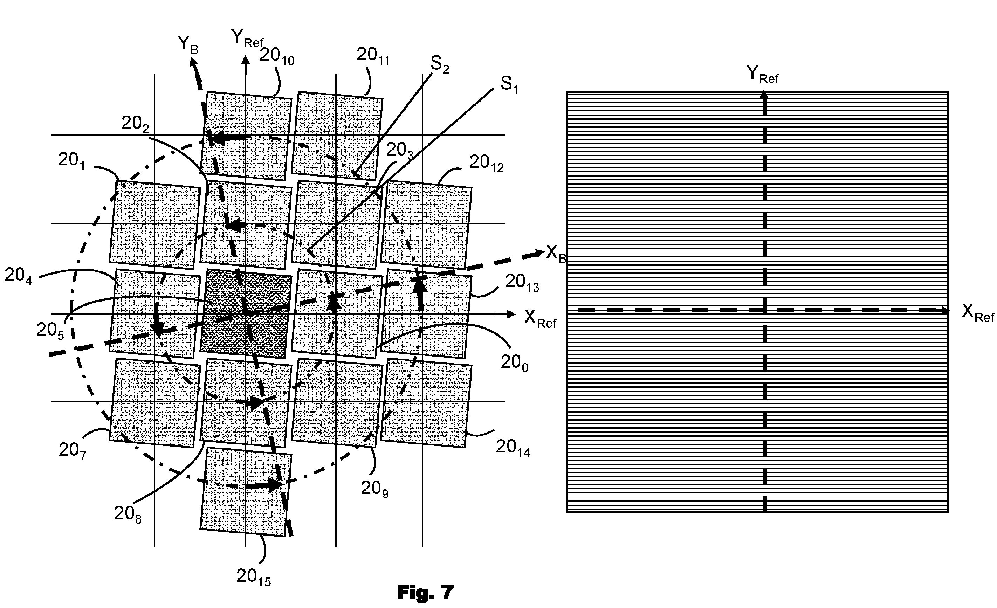

Figure 7a shows by way of example a shell-wise defect detection comprising a registration of a plurality of sample images $20_i$, wherein the plurality of sample images $20_i$ have a distortion in the form of a rotation with respect to the reference image. Figure 7a shows the general case in which different distortions are superposed on top of each another (overlay of the distortions illustrated in Figures 6A and 6B). Figure 7 shows on the right the reference coordinate system having the reference axes $X_{Ref}$ and $Y_{Ref}$.

For the method for defect detection according to the invention, first a sample image is selected as a base sample image: Said base sample image is denoted in the example shown by the reference sign $20_5$. It is selected such that structures (not illustrated) that are located with great certainty in the sample image $20_5$ can be reliably

assigned to the corresponding structures in the reference image. Next, a defect detection of the base sample image $20_5$ is carried out in the manner described, wherein the associated sample image regions are registered in a sample-image-region-wise manner in the sample image $20_5$. Next, a selection of first sample images that are arranged in a first shell $S_1$ around the base sample image $20_5$ is carried out: In the example shown, these are the sample images $20_1$ to $20_4$ and $20_6$ to $20_9$. Due to their spatial proximity to the base sample image $20_5$ defect detection and registration in a sample-image-region-wise manner also succeeds quite well for the sample images of the first shell $S_1$. After the registration and defect detection, a first angle of rotation for the distortion is determined: Said angle of rotation is indicated in the dash-dotted circle $S_1$ by way of the small black arrows. In a further method step, second sample images arranged in a second shell $S_2$ around the base sample image $20_5$ are then selected; in the example illustrated, only some sample images of the second shell are illustrated, specifically the sample images $20_{10}$ to $20_{15}$. Before the start of the defect detection comprising the registration of the sample images $20_{10}$ to $20_{15}$, or more generally of the registration of the sample images in the second shell $S_2$, their positions are corrected based on the determined first angle of rotation. In this way, central regions of the sample images $20_{10}$ to $20_{15}$ can be prevented from moving ever farther with respect to the reference system, until finally no more assignment between sample images and reference images would be possible at all. After the correction of the rotation, the second individual sample images $20_{10}$ to $20_{15}$ are then registered in the manner already described and the method for defect detection is carried out for the second individual sample images $20_{10}$ to $20_{15}$, that is to say in a sample-image-region-wise manner. In a further method step, an angle of rotation can be determined again and the method can be carried out as a whole for sample images of a further shell or for sample images of further shells. The more sample images are used for determining the angle of rotation, the more accurately it can be determined, and the better will be the distortion correction as a whole. Consequently, a better defect detection becomes possible in a pixel-based comparison following the registration steps.

The method for defect detection in a sample, in particular in a semiconductor sample, according to the invention enables a significant reduction or prevention of false-positive defect detections by way of the sample-image-region-wise registration. This is true both for sample images recorded by means of individual beam particle beam inspection systems and also for sample images recorded by means of multiple particle beam inspection systems. In the latter case, shell-wise sample image region-wise registration of the plurality of sample images before the pixel-based comparison of all the corrected sample image regions with the respectively assigned reference image regions for defect detection can even further improve the method.

List of reference signs

| | |
|---|---|
| 1 | Multi-beam particle microscope |
| 3 | Primary particle beams (individual particle beams) |
| 5 | Beam spots, incidence locations |
| 7 | Object |
| 8 | Sample stage |
| 9 | Secondary particle beams |
| 10 | Computer system, controller |
| 11 | Secondary particle beam path |
| 13 | Primary particle beam path |
| 20 | Sample image |
| 21 | Side of the sample image |
| 22 | Side of the sample image |
| 23 | Structure |
| 24 | Structure |
| 25 | Structure |
| 26 | Structure |
| 27 | Structure |
| 28 | Structure |
| 29 | Structure |
| 30 | Structure |
| 31 | Structure |
| 32 | Structure |
| 40 | Sample image region (patch) |
| 41 | Sample image region (patch) |
| 42 | Sample image region (patch) |
| 43 | Sample image region (patch) |
| 44 | Sample image region (patch) |
| 45 | Sample image region (patch) |
| 46 | Sample image region (patch) |
| 47 | Sample image region (patch) |
| 48 | Sample image region (patch) |
| 52 | Arrow for marking the distortion (rotation) |
| 55 | Arrow for marking the distortion (rotation) |
| 56 | Arrow for marking the distortion (rotation) |
| 57 | Arrow for marking the distortion (rotation) |
| 60 | Coordinate origin, centre of the sample image region $20_5$ (base sample image region) |
| 69 | Centre of the sample image region $20_9$ |
| 100 | Objective lens system |
| 101 | Object plane |
| 102 | Objective lens |
| 103 | Field |
| 110 | Aperture |
| 200 | Detector system |
| 205 | Projection lens |
| 207 | Detection region |
| 209 | Particle multi-detector |
| 211 | Detection plane |
| 213 | Incidence locations |
| 215 | Detection region |
| 217 | Field |
| 300 | Beam generating apparatus |
| 301 | Particle source |

| 303 | Collimation lens system |
| 305 | Multi-aperture arrangement |
| 306 | Micro-optics |
| 307 | Field lens system |
| 309 | Diverging particle beam |
| 311 | Illuminating particle beam |
| 313 | Multi-aperture plate |
| 315 | Openings in the multi-aperture plate |
| 317 | Midpoints of the openings |
| 319 | Field |
| 323 | Beam foci |
| 325 | Intermediate image plane |
| 400 | Beam switch |
| $x_{Ref}$ | x-axis of the reference image |
| $y_{Ref}$ | y-axis of the reference image |
| $\Delta x$ | Lateral offset in the x-direction |
| $\Delta y$ | Lateral offset in the y-direction |
| S1 | First shell |
| S2 | Second shell |
| $A_{PBx}$ | Edge length of a sample image region in the x-direction |
| $A_{PBy}$ | Edge length of a sample image region in the y-direction |

**Claims**

1. Method for defect detection in a sample, in particular in a semiconductor sample, including the following steps:

    a) providing a reference image of the sample;
    b) providing a sample image (20) generated by means of a particle beam inspection system (1), wherein the sample image (20) comprises a rotation with respect to the reference image as a distortion;
    c) dividing the sample image (20) into sample image regions (40-48);
    d) dividing the reference image into reference image regions, wherein each sample image region (40-48) is assigned one reference image region to form an image region pair;
    e) identifying in each image region pair a structure (23-32) that is present both in the sample image region (40-48) and also in the assigned reference image region of the image region pair;
    f) registering the sample image regions (40-48) by correcting a lateral offset of the identified structure (23-32) in each sample image region (40-48) on the basis of the location of the identified structure (23-32) in the respectively assigned reference image region (40-48), as a result of which corrected sample image regions are formed; and
    g) comparing each corrected sample image region pixel by pixel with the respectively associated reference image region for defect detection;

**characterized in that**

    the particle beam inspection system is a multiple particle beam system (1) operating with a plurality of individual particle beams (3) and comprises a single column for the plurality of individual particle beams (3);
    wherein the method is carried out for a plurality of sample images (20), wherein each sample image (20) is generated by means of an individual particle beam (3) assigned thereto;
    wherein the method is carried out for the plurality of sample images (20) in a shell-wise manner, the method furthermore including the following steps:

    selecting a sample image (20i) as base sample image ($20_5$);
    carrying out the method steps a) to g) for defect detection for the base sample image (205);
    selecting first sample images (20i) that are arranged in a first shell (S1) around the base sample image ($20_5$);
    carrying out the method steps a) to g) for defect detection for the first sample images (20i) and
    determining a first angle of rotation for the distortion based on the sample image region-wise registration of the first sample images (20i) of the first shell (1).

2. The method according to claim 1, furthermore including the following steps:

    providing an expected defect size $A_{Def}$; and
    defining an edge length $A_{PB}$ of the sample image region such that the edge length $A_{PB}$ is at least five times the size of a distortion $\vec{\Delta}(\vec{r})$ maximally occurring in the sample image region (40-48), thus

$$A_{PB} \geq 5 \max_{\vec{r} \in Bild\_PB} \left| \vec{\Delta}(\vec{r}) \right|$$

3. The method according to either of the preceding claims, furthermore including the following steps:

    providing an expected defect size $A_{Def}$; and
    defining an edge length $A_{PB}$ of the sample image region (40-48) such that a location-dependent distortion $\vec{\Delta}(\vec{r})$, does not change more significantly over a sample image region (40-48) than half the expected defect size $A_{Def}$, thus

$$A_{PB} \leq A_{Def} * \left( \frac{1}{|grad|\overline{\overline{\Delta}}||} \right),$$

wherein $|grad|\vec{\Delta}||$ denotes the absolute value of the gradient of the location-dependent distortion $\vec{\Delta}(\vec{x})$.

4. The method according to any of the preceding claims,
wherein the respective lateral offset of the respectively identified structure (23-32) is corrected in two directions which are linearly independent with respect to one another, in particular in two mutually orthogonal directions.

5. The method according to any one of the preceding claims,
wherein a size of the sample image regions (40-48) is selected to be small enough, when dividing the sample image (20), such that a shape of the sample image regions (40-48) does not substantially change due to the distortion.

6. The method according to the preceding claim,

wherein the sample image regions (40-48) are quadrangular, in particular rectangular or square, and
wherein the distances between the corners of the sample image regions (40-48) are shifted relative to one another with respect to the associated distances between the corners of the reference image regions relative to one another due to the distortion by no more than a predetermined number of pixels.

7. The method according to the preceding claim,
wherein the distances between the corners of the sample image regions (40-48) are shifted relative to one another with respect to the associated distances between the corners of the reference image regions relative to one another due to the distortion by no more than half an expected defect size.

8. The method according to any of the preceding claims,

wherein mutually adjacent sample image regions (40-48) have an overlap, and
wherein the respective overlap is selected to be at least as large as the size of an expected defect.

9. The method according to any of the preceding claims,

wherein the sample image (20) has, with respect to the reference image, in addition to the rotation another affine distortion; and/or
wherein the sample image (20) has, with respect to the reference image, in addition to the rotation a non-linear distortion.

10. The method as claimed in any one of the preceding claims, furthermore including the following step:
determining a distortion function or a distortion pattern for the sample image (20) on the basis of the corrected lateral offset of the sample image regions (40-48) during registration.

11. The method according to any one of the preceding claims, furthermore including the following step:
determining a rotation angle of the sample image (20) with respect to the reference image.

12. The method according to the preceding claim, furthermore including the following step:
adjusting and/or calibrating the particle beam inspection system (1) on the basis of the distortion function and/or the distortion pattern.

13. The method as claimed in any one of the preceding claims, furthermore including the following step:
coarsely registering the sample image (20) with respect to the reference image.

14. The method according to one of Claims 1 to 13, wherein the particle beam inspection system (1) is a multi-beam electron microscope (MSEM) operating with a plurality of individual particle beams.

15. The method according to any one of Claims 1 to 14,

wherein the sample images (20) are arranged hexagonally with respect to one another; and/or
wherein the sample images (20) have an overlap with adjacent sample images (20).

16. The method according to any one of claims 1 to 15, furthermore including the following steps:

selecting second sample images (20i) that are arranged in a second shell (S2) around the base sample image (20$_5$);
correcting a position of the second sample images (20i) based on the determined first angle of rotation; and
carrying out the method steps a) to g) for defect detection for the position-corrected second sample images.

17. The method according to the preceding claim, furthermore including the following step:
determining a second angle of rotation for the distortion based on the sample image region-wise registration of the second sample images (20i) of the second shell (S2).

18. The method according to the preceding claim, furthermore including the following steps:

selecting third sample images(20i) that are arranged in a third shell (S3) around the base sample image ($20_5$);

correcting a position of the third sample images (20i) based on the determined second angle of rotation; and

carrying out the method steps a) to g) for defect detection for the position-corrected third individual sample images (20i).

19. The method according to the preceding claim, wherein the method steps a) to g) for defect detection are carried out for a further shell or for further shells of sample images (20i).

20. Computer program product comprising a program code for carrying out the method according to any one of claims 1 to 19.

**Patentansprüche**

1. Verfahren für eine Fehlererkennung in einer Probe, insbesondere in einer Halbleiterprobe, das die folgenden Schritte aufweist:

a) Bereitstellen eines Referenzbildes der Probe;
b) Bereitstellen eines Probenbildes (20), das mithilfe eines Teilchenstrahlinspektionssystems (1) erzeugt wird, wobei das Probenbild (20) eine Drehung in Bezug auf das Referenzbild als eine Verzerrung umfasst;
c) Aufteilen des Probenbildes (20) in Probenbildgebiete (40-48);
d) Aufteilen des Referenzbildes in Referenzbildgebiete, wobei jedem Probenbildgebiet (40-48) ein Referenzbildgebiet zugewiesen wird, um ein Bildgebietspaar zu bilden;
e) Identifizieren in jedem Bildgebietspaar einer Struktur (23-32), die sowohl in dem Probenbildgebiet (40-48) als auch in dem zugewiesenen Referenzbildgebiet des Bildgebietspaars vorhanden ist;
f) Registrieren der Probenbildgebiete (40-48), indem ein lateraler Versatz der identifizierten Struktur (23-32) in jedem Probenbildgebiet (40-48) auf der Grundlage des Orts der identifizierten Struktur (23-32) in dem jeweils zugewiesenen Referenzbildgebiet (40-48) korrigiert wird, aufgrund dessen korrigierte Probenbildgebiete gebildet werden; und
g) Vergleichen jedes korrigierten Probenbildgebiets Pixel für Pixel mit dem jeweils assoziierten Referenzbildgebiet für die Fehlererkennung;

**dadurch gekennzeichnet, dass**

das Teilchenstrahlinspektionssystem ein Mehrfachteilchenstrahlsystem (1) ist, das mit einer Vielzahl von Einzelteilchenstrahlen (3) arbeitet und eine einzelne Säule für die Vielzahl von Einzelteilchenstrahlen (3) umfasst;
wobei das Verfahren für eine Vielzahl von Probenbildern (20) durchgeführt wird, wobei jedes Probenbild (20) mithilfe eines ihm zugewiesenen Einzelteilchenstrahls (3) erzeugt wird;
wobei das Verfahren für die Vielzahl von Probenbildern (20) in einer schalenartigen Weise durchgeführt wird, wobei das Verfahren ferner die folgenden Schritte aufweist:

Auswählen eines Probenbildes (20i) als Basisprobenbild ($20_5$) ;
Ausführen der Verfahrensschritte a) bis g) für eine Fehlererkennung für das Basisprobenbild (205);
Auswählen von ersten Probenbildern (20i), die in einer ersten Schale (S1) um das Basisprobenbild ($20_5$) herum angeordnet sind;
Durchführen der Verfahrensschritte a) bis g) für eine Fehlererkennung für die ersten Probenbilder (20i);
Ermitteln eines ersten Drehwinkels für die Verzerrung basierend auf der gebietsweisen Registrierung von Probenbildern der ersten Probenbilder (20i) der ersten Schale (1).

2. Verfahren nach Anspruch 1, das ferner die folgenden Schritte aufweist:

Bereitstellen einer erwarteten Fehlergröße $A_{DEF}$; und
Definieren einer Kantenlänge $A_{PB}$ des Probenbildgebiets, sodass die Kantenlänge $A_{PB}$ mindestens das Fünffache der Größe einer Verzerrung $\vec{\Delta}(\vec{r})$ beträgt, die in dem Probenbildgebiet (40-48) maximal auftritt, wodurch gilt:

$$A_{PB} \geq 5 \max_{\vec{r} \in Bild\_PB} \left| \vec{\Delta}\left(\vec{r}\right) \right|$$

3. Verfahren nach einem der vorhergehenden Ansprüche, das ferner die folgenden Schritte aufweist:

Bereitstellen einer erwarteten Fehlergröße $A_{DEF}$; und
Definieren einer Kantenlänge $A_{PB}$ des Probenbildgebiets (40-48), sodass sich eine ortsabhängige Verzerrung $\vec{\Delta}(\vec{x})$ über einem Probenbildgebiet (40-48) nicht signifikanter ändert als die Hälfte der erwarteten Fehlergröße $A_{DEF}$, wodurch gilt:

$$A_{PB} \leq A_{Def} * \left(\frac{1}{\left|grad\overrightarrow{|\Delta|}\right|}\right),$$

wobei $|grad|\vec{\Delta}|$ den Absolutwert des Gradienten der ortsabhängigen Verzerrung $\vec{\Delta}$ ($\vec{x}$) bezeichnet.

4. Verfahren nach einem der vorhergehenden Ansprüche, wobei der jeweilige laterale Versatz der jeweils identifizierten Struktur (23-32) in zwei Richtungen korrigiert wird, die linear unabhängig voneinander sind, insbesondere in zwei gegenseitig orthogonalen Richtungen.

5. Verfahren nach einem der vorhergehenden Ansprüche, wobei eine Größe der Probenbildgebiete (40-48) klein genug ausgewählt wird, damit sich, wenn das Probenbild (20) aufgeteilt wird, eine Form der Probenbildgebiete (40-48) aufgrund der Verzerrung nicht wesentlich ändert.

6. Verfahren nach dem vorhergehenden Anspruch,

   wobei die Probenbildgebiete (40-48) viereckig, insbesondere rechteckig oder quadratisch sind, und
   wobei die Abstände zwischen den Ecken der Probenbildgebiete (40-48), in Bezug auf die assoziierten Abstände zwischen den Ecken der Referenzbildgebiete relativ zueinander, aufgrund der Verzerrung um nicht mehr als eine vorbestimmte Anzahl von Pixeln relativ zueinander verschoben sind.

7. Verfahren nach dem vorhergehenden Anspruch, wobei die Abstände zwischen den Ecken der Probenbildgebiete (40-48), in Bezug auf die assoziierten Abstände zwischen den Ecken der Referenzbildgebiete relativ zueinander, aufgrund der Verzerrung um nicht mehr als eine Hälfte einer erwarteten Fehlergröße relativ zueinander verschoben sind.

8. Verfahren nach einem der vorhergehenden Ansprüche,

   wobei gegenseitig benachbarte Probenbildgebiete (40-48) eine Überlappung aufweisen, und
   wobei die jeweilige Überlappung so ausgewählt wird, dass sie mindestens so groß wie die Größe eines erwarteten Fehlers ist.

9. Verfahren nach einem der vorhergehenden Ansprüche,

   wobei das Probenbild (20) zusätzlich zu der Drehung eine weitere affine Verzerrung in Bezug auf das Referenzbild aufweist; und/oder

wobei das Probenbild (20) zusätzlich zu der Drehung eine nichtlineare Verzerrung in Bezug auf das Referenzbild aufweist.

10. Verfahren nach einem der vorhergehenden Ansprüche, das ferner den folgenden Schritt aufweist: Ermitteln einer Verzerrungsfunktion oder eines Verzerrungsmusters für das Probenbild (20) auf der Grundlage des korrigierten lateralen Versatzes der Probenbildgebiete (40-48) während der Registrierung.

11. Verfahren nach einem der vorhergehenden Ansprüche, das ferner den folgenden Schritt aufweist: Ermitteln eines Drehwinkels des Probenbildes (20) in Bezug auf das Referenzbild.

12. Verfahren nach dem vorhergehenden Anspruch, das ferner den folgenden Schritt aufweist: Anpassen und/oder Kalibrieren des Teilchenstrahlinspektionssystems (1) auf der Grundlage der Verzerrungsfunktion und/oder des Verzerrungsmusters.

13. Verfahren nach einem der vorhergehenden Ansprüche, das ferner den folgenden Schritt aufweist: grobes Registrieren des Probenbildes (20) in Bezug auf das Referenzbild.

14. Verfahren nach einem der Ansprüche 1 bis 13, wobei das Teilchenstrahlinspektionssystem (1) ein Mehrstrahl-Elektronenmikroskop (MSEM) ist, das mit einer Vielzahl von einzelnen Teilchenstrahlen arbeitet.

15. Verfahren nach einem der Ansprüche 1 bis 14,

   wobei die Probenbilder (20) hexagonal in Bezug zueinander angeordnet sind; und/oder
   wobei die Probenbilder (20) eine Überlappung mit benachbarten Probenbildern (20) aufweisen.

16. Verfahren nach einem der Ansprüche 1 bis 15, das ferner die folgenden Schritte aufweist:

   Auswählen von zweiten Probenbildern (20i), die in einer zweiten Schale (S2) um das Basisprobenbild ($20_5$) herum angeordnet sind;
   Korrigieren einer Position der zweiten Probenbilder (20i) basierend auf dem ermittelten ersten Drehwinkel; und
   Ausführen der Verfahrensschritte a) bis g) für eine Fehlererkennung für die positionskorrigierten zweiten Probenbilder.

17. Verfahren nach dem vorhergehenden Anspruch, das ferner den folgenden Schritt aufweist:

Ermitteln eines zweiten Drehwinkels für die Verzerrung basierend auf der gebietsweisen Registrierung von Probenbildern der zweiten Probenbilder (20i) der zweiten Schale (S2).

18. Verfahren nach dem vorhergehenden Anspruch, das ferner die folgenden Schritte aufweist:

Auswählen von dritten Probenbildern (20i), die in einer dritten Schale (S3) um das Basisprobenbild (20$_5$) herum angeordnet sind;
Korrigieren einer Position der dritten Probenbilder (20i) basierend auf dem ermittelten zweiten Drehwinkel; und
Ausführen der Verfahrensschritte a) bis g) für eine Fehlererkennung für die positionskorrigierten dritten einzelnen Probenbilder (20i).

19. Verfahren nach dem vorhergehenden Anspruch, wobei die Verfahrensschritte a) bis g) für eine Fehlererkennung für eine weitere Schale oder für weitere Schalen von Probenbildern (20i) ausgeführt werden.

20. Computerprogrammprodukt, das einen Programmcode zum Ausführen des Verfahrens nach einem der Ansprüche 1 bis 19 umfasst.


**Revendications**

1. Procédé de détection de défauts dans un échantillon, en particulier dans un échantillon semi-conducteur, comprenant les étapes suivantes :

a) la fourniture d'une image de référence de l'échantillon ;
b) la fourniture d'une image d'échantillon (20) générée au moyen d'un système d'inspection par faisceau de particules (1), l'image d'échantillon (20) comprenant une rotation par rapport à l'image de référence en tant qu'une distorsion ;
c) la division de l'image d'échantillon (20) en régions d'image d'échantillon (40-48) ;
d) la division de l'image de référence en régions d'image de référence, chaque région d'image d'échantillon (40-48) étant attribuée à une région d'image de référence pour former une paire de région d'image ;
e) l'identification, dans chaque paire de régions d'image, d'une structure (23-32) qui est présente à la fois dans la région d'image d'échantillon (40-48) et également dans la région d'image de référence attribuée de la paire de régions d'image ;
f) le recalage des régions d'image d'échantillon (40-48) en corrigeant un décalage latéral de la structure identifiée (23-32) dans chaque région d'image d'échantillon (40-48) sur la base de l'emplacement de la structure identifiée (23-32) dans la région d'image de référence respectivement attribuée (40-48), en conséquence de quoi des régions d'image d'échantillon corrigées sont formées ; et
g) la comparaison de chaque région d'image d'échantillon corrigée pixel par pixel à la région d'image de référence respectivement associée pour une détection de défauts ;

**caractérisé en ce que**

le système d'inspection par faisceau de particules est un système à faisceau de particules multiple (1) fonctionnant avec une pluralité de faisceaux de particules individuels (3) et comprenant une colonne unique pour la pluralité de faisceaux de particules individuels (3) ;
le procédé étant mis en œuvre pour une pluralité d'images d'échantillon (20), chaque image d'échantillon (20) étant générée au moyen d'un faisceau de particules individuel (3) qui lui est attribué ;
le procédé étant réalisé pour la pluralité d'images d'échantillon (20) de façon couche par couche, le procédé comprenant en outre les étapes suivantes :

la sélection d'une image d'échantillon (20i) comme image d'échantillon de base (20$_5$) ;
la réalisation des étapes a) à g) de procédé pour la détection de défaut pour l'image d'échantillon de base (205) ;
la sélection de premières images d'échantillon (20i) qui sont agencées dans une première couche (S1) autour de l'image d'échantillon de base (20$_5$) ;
la mise en œuvre des étapes a) à g) du procédé de détection de défauts pour les premières images d'échantillon (20i), et
la détermination d'un premier angle de rotation pour la distorsion sur la base du recalage par région d'image d'échantillon des premières images d'échantillon (20i) de la première couche (1).

2. Procédé selon la revendication 1, comprenant en outre les étapes suivantes :

la fourniture d'une taille de défaut attendue de A$_{Def}$ ; et
la définition d'une longueur d'arête A$_{PB}$ de la région d'image d'échantillon de telle sorte que la longueur d'arête A$_{PB}$ soit au moins cinq fois la taille d'une distorsion $\vec{\Delta}(\vec{r})$ se produisant au maximum dans la région d'image d'échantillon (40-48), ainsi

$$A_{PB} \geq 5 \max_{\vec{r} \in Bild\_PB} \left| \vec{\Delta}\left(\vec{r}\right) \right|$$

**3.** Procédé selon l'une des revendications précédentes, comprenant en outre les étapes suivantes :

> la fourniture d'une taille de défaut attendue de $A_{Def}$ ; et
> la définition d'une longueur d'arête $A_{PB}$ de la région d'image d'échantillon (40-48) de telle sorte qu'une distorsion dépendant de l'emplacement $\vec{\Delta}(\vec{x})$, ne change pas plus significativement sur une région d'image d'échantillon (40-48) que la moitié de la taille de défaut attendue $A_{Def}$, ainsi

$$A_{PB} \leq A_{Def} * \left( \frac{1}{\left| grad \left| \vec{\Delta} \right| \right|} \right),$$

> $\left| grad \left| \vec{\Delta} \right| \right|$ désignant la valeur absolue du gradient de la distorsion fonction de la localisation $\vec{\Delta}(\vec{x})$.

**4.** Procédé selon l'une quelconque des revendications précédentes,
le décalage latéral respectif de la structure (23-32) respectivement identifiée étant corrigé selon deux directions qui sont linéairement indépendantes l'une par rapport à l'autre, en particulier dans deux directions orthogonales entre elles.

**5.** Procédé selon l'une quelconque des revendications précédentes,
une taille des régions d'image d'échantillon (40-48) étant choisie suffisamment petite, lors de la division de l'image d'échantillon (20), de sorte qu'une forme des régions d'image d'échantillon (40-48) ne change pas sensiblement en raison de la distorsion.

**6.** Procédé selon la revendication précédente,

> les régions d'image d'échantillon (40-48) étant quadrangulaires, en particulier rectangulaires ou carrées, et,
> les distances entre les coins des régions d'image d'échantillon (40-48) étant décalées les unes par rapport aux autres par rapport aux distances associées entre les coins des régions d'image de référence les unes par rapport aux autres en raison de la distorsion de pas plus d'un nombre prédéterminé de pixels.

**7.** Procédé selon la revendication précédente,
les distances entre les coins des régions d'image d'échantillon (40-48) étant décalées les unes par rapport aux autres par rapport aux distances associées entre les coins des régions d'image de référence les unes par rapport aux autres en raison de la distorsion de pas plus de la moitié d'une taille de défaut attendue.

**8.** Procédé selon l'une quelconque des revendications précédentes,

> des régions d'image d'échantillon mutuellement adjacentes (40-48) comprenant un chevauchement, et
> le recouvrement respectif étant sélectionné pour être au moins aussi grand que la taille d'un défaut attendu.

**9.** Procédé selon l'une quelconque des revendications précédentes,

> l'image d'échantillon (20) ayant, par rapport à l'image de référence, outre la rotation, une autre distorsion affine ; et/ou
> l'image d'échantillon (20) ayant, par rapport à l'image de référence, outre la rotation, une distorsion non linéaire.

**10.** Procédé selon l'une quelconque des revendications précédentes, comprenant en outre l'étape suivante :
la détermination d'une fonction de distorsion ou d'un motif de distorsion pour l'image d'échantillon (20) sur la base du décalage latéral corrigé des régions d'image d'échantillon (40-48) pendant le recalage.

**11.** Procédé selon l'une quelconque des revendications précédentes, comprenant en outre l'étape suivante :
la détermination d'un angle de rotation de l'image d'échantillon (20) par rapport à l'image de référence.

**12.** Procédé selon la revendication précédente, comprenant en outre l'étape suivante :
le réglage et/ou l'étalonnage du système d'inspection par faisceau de particules (1) sur la base de la fonction de distorsion et/ou du motif de distorsion.

**13.** Procédé selon l'une quelconque des revendications précédentes, comprenant en outre l'étape suivante :
le recalage grossier de l'image d'échantillon (20) par rapport à l'image de référence.

**14.** Procédé selon l'une quelconque des revendications 1 à 13,
le système d'inspection par faisceau de particules (1) étant un microscope électronique multifaisceaux (MSEM) fonctionnant avec une pluralité de faisceaux de particules individuels.

**15.** Procédé selon l'une quelconque des revendications 1 à 14,

> les images d'échantillon (20) étant agencées de manière hexagonale les unes par rapport aux autres ; et/ou
les images d'échantillon (20) ayant un chevauchement avec des images d'échantillon adjacentes (20).

16. Procédé selon l'une quelconque des revendications 1 à 15, comprenant en outre les étapes suivantes :

la sélection de deuxièmes images d'échantillon (20i) qui sont agencées dans une deuxième couche (S2) autour de l'image d'échantillon de base ($20_5$) ;
la correction d'une position des deuxièmes images d'échantillon (20i) sur la base du premier angle de rotation déterminé ; et
la mise en œuvre des étapes a) à g) du procédé de détection de défauts pour les deuxièmes images d'échantillon corrigées en position.

17. Procédé selon la revendication précédente, comprenant en outre l'étape suivante :
la détermination d'un second angle de rotation pour la distorsion sur la base du recalage par région **d'image d'échantillon** des deuxièmes images **d'échantillon** (20i) de la deuxième couche (S2).

18. Procédé selon la revendication précédente, comprenant en outre les étapes suivantes :

la sélection de troisièmes images d'échantillon (20i) qui sont agencées dans une troisième couche (S3) autour de l'image d'échantillon de base ($20_5$) ;
la correction d'une position des troisièmes images d'échantillon (20i) sur la base du second angle de rotation déterminé ; et
la mise en œuvre des étapes a) à g) du procédé de détection de défauts pour les troisièmes images d'échantillon individuelles (20i) corrigées en position.

19. Procédé selon la revendication précédente, les étapes a) à g) du procédé de détection de défauts étant mises en œuvre pour une couche supplémentaire ou pour des couches supplémentaires d'images d'échantillon (20i).

20. Produit de programme informatique comprenant un code de programme pour la mise en œuvre du procédé selon l'une quelconque des revendications 1 à 19.

Fig. 1

**Fig. 2**

**Fig. 3**

EP 4 377 884 B1

**Fig. 4**

EP 4 377 884 B1

Fig. 5

**Fig. 6**

**Fig. 7**

EP 4 377 884 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7244949 B2
- US 20190355544 A1
- DE 102020206739
- US 2019114758 A1
- US 2019122913 A1
- DE 102021119008
- US 6921916 B2
- US 6580505 B1

- US 5777392 A
- WO 2005024881 A2
- WO 2007028595 A2
- WO 2007028596 A1
- WO 2011124352 A1
- WO 2007060017 A2
- DE 102013016113 A1
- DE 102013014976 A1

### Non-patent literature cited in the description

- **NAKAGAKI, RYO ; HONDA, TOSHIFUMI ; NAKA-MAE, KOJI**. Automatic recognition of defect areas on a semiconductor wafer using multiple scanning electron images.. *Measurement Science and Technology*, 2009, vol. 20, 075503

- **A.L. EBERLE et al.** High-resolution, high-throughput imaging with a multibeam scanning electron microscope : HIGH-THROUGHPUT IMAGING WITH A MULTIBEAM SEM. *JOURNAL OF MICROSCOPY*, 01 August 2015, vol. 259 (2), ISSN ISSN: 0022-2720, 114-120